# EUROPEAN PATENT APPLICATION

(11) **EP 4 835 950 A1**
(43) Date of publication of application: **04.11.2026**
(21) Application number: 25460017.4
(22) Date of filing: 30.04.2025
(51) Int. Cl.: H01J 37/32

(54) **MULTI-OUTPUT MATCHING DEVICE**

(71) Applicant: TRUMPF Huettinger Sp. z o.o., 05-220 Zielonka (PL)
(72) Inventor: The designation of the inventor has not yet been filed
(74) Representative: Trumpf Patentabteilung

(57) **Abstract**

The application provides a multi-output matching device, the multi-output matching device comprises a housing, and at least two sets of matching circuits are arranged in the housing, and each set of matching circuits comprises: an output terminal; At least one RF circuit, including an RF input that is electrically connected to the output, to achieve impedance matching from input to output; At least one LF circuit, including a LF input and resonant circuit; The resonant circuit is electrically connected between the LF input and output. Through the scheme provided in this application, the impedance matching of a wider frequency can be effectively realized and the equipment integration can be improved.

## Description

### Technical Field:

The present invention relates a multi-output matching device, in particular in a plasma application field.

### Technical Background:

In a typical RF discharge plasma generation system, the output impedance of the RF power supply is generally 50 Ω. With such a 50 Ω output, an adequate choice of cables, connectors, and measurement equipment is available, to connect the RF power supply with the plasma generation system. On the plasma side, the equivalent impedance of the plasma reaction chamber is generally not 50 Ω, it is often not a real part value, but rather a complex value like Z = (R + jX) wherein Z is the complex impedance, R is the real part and X is the imaginary part of this impedance. Additionally, the equivalent impedance of the plasma reaction chamber is also different from each other under different process conditions. The transmission line theory points out that when the output impedance of the RF power supply is different from the load impedance, that is, the equivalent impedance of the plasma reaction chamber, the output power of the RF power supply cannot be fully delivered to the load. A part of the power will be reflected to the RF power supply, and the system efficiency cannot be maximized. This may result in energy waste, may also cause damage to the RF power supply itself, and may even lead to safety problems such as fire caused by excessive local heat. And because the size of the load impedance is related to the process conditions for generating plasma, e.g. in the process of using the inductively coupled plasma source, it is a usual practice to add an impedance matcher that can automatically adjust the load impedance between the RF power supply and the plasma reaction chamber. The impedance matcher can change an actual value of an adjustable parameter device, such as an adjustable capacitor. This is usually controlled with a measuring equipment, in particular able to measure an impedance and corresponding phase, at an input of the impedance matcher and a control system, built in the impedance matcher. The adjustable parameter device is adjusted in a way, that the impedance at the input of the impedance matcher is as close as possible to 50 Ω. The impedance matcher is arranged closely to the plasma chamber. The control is done according to the actual impedance of the plasma reaction chamber under different process conditions, so that the load impedance seen by the RF power supply is equal to 50 Ω.

Ore and more plasma generation systems have often the need of more than one plasma exciting frequency, so called multi-frequency plasma generation systems.

Additionally, more and more plasma generation systems need more than one power generation input. Prior art impedance matchers are mostly single-frequency circuits, which cannot meet many use scenarios that require multi-frequency inputs. So, several such impedance matchers are needed, one for each frequency.

Whan a plasma generation system comprises more than one of multilevel-inputs, even more such impedance matchers are needed. A "impedance matcher" is also called "matching device".

In the past, such configurations often generated oscillations, where the real cause for those oscillations were unknown. Those oscillations could cause control breakdowns and damage, especially in high power and/or high voltage applications.

It is therefor an object of the present invention to provide a matching device which makes the plasma generation system, more reliable and reduces the risk of damage.

### Application content:

The application discloses a multi-output matching device for realizing the function of simultaneous dual outputs and realizing the function that each output can connect with LF and RF matching functions separately or together.

With "LF" is meant "low frequency" which should be here a frequency below 1 MHz, in particular equal or below 600 kHz.

With "RF" is meant "radio frequency" which should be here a frequency equal or above 1 MHz, in particular equal or above 10 MHz.

The multi-output matching device disclosed in the application comprises a housing, and at least two sets of matching circuits which are arranged in the housing, and each set of matching circuits comprises:
- an output;
- an RF input;
- an LF input;
- an RF circuit; and
- an LF circuit.

The RF circuit is electrically connected to the respective RF input and the respective output, for realizing impedance matching from the respective input to the respective output.

The LF circuit is electrically connected between the respective LF input and the respective output.

In such a way, the aforementioned object can be achieved in very good manner.

In an aspect, one, several, or each input and/or output may be a connection point, in particular a plug. It may be arranged at the housing, in particular outside of the housing. It may be made of metal.

In such a way, the aforementioned object can be achieved even better.

In an aspect, a, in particular each, resonant circuit comprises a resonant circuit which comprises a resonant inductor and a resonant capacitor connected electrically in parallel, respectively.

In such a way, the aforementioned object can be achieved even better.

In an aspect, the resonant inductor is spatially arranged around the respective resonant capacitor.

In such a way, the aforementioned object can be achieved even better.

In an aspect, a, in particular each, RF circuit comprises a first inductor, a first variable capacitor, a second variable capacitor.

In an aspect, several of, in particular all, those components are connected in series connection.

In such a way, the aforementioned object can be achieved even better.

In an aspect, an input end of the first inductor is connected to the RF input.

In such a way, the aforementioned object can be achieved even better.

In an aspect, an output end of the second inductor is connected to the output.

In such a way, the aforementioned object can be achieved even better.

In an aspect, a, in particular each, RF circuit comprises at least one RF grounding inductor. The RF grounding inductor comprises a grounding end and a signal end.

In an aspect, the grounding end of the RF grounding inductor is connected to the ground.

In an aspect, the signal end of the RF grounding inductor is connected between the RF input and the output.

In such a way, the aforementioned object can be achieved even better.

In an aspect, a, in particular each, inductor is made of a copper tube, floodable with a cooling fluid, e.g. cooling water.

In an aspect, a, in particular each, RF grounding inductor is electrically connected with its signal end at the point between the respective first and respective second variable capacitor.

In such a way, the aforementioned object can be achieved even better.

In an aspect, a, in particular each, resonant inductor is electrically connected between the first inductor, and the second inductor.

In such a way, the aforementioned object can be achieved even better.

In an aspect, a, in particular each, resonant inductor is electrically connected between the first variable capacitor and the second inductor.

In such a way, the aforementioned object can be achieved even better.

In an aspect, a, in particular each, resonant inductor is electrically connected between the first inductor, and the the second variable capacitor.

In such a way, the aforementioned object can be achieved even better.

In an aspect, a, in particular each, resonant circuit has a respective resonant input end, connected to the respective LF input and a respective resonant output end, connected to the respective output.

In an aspect, a, in particular each, resonant inductor has a respective input end, connected to the respective LF input and a respective output end, connected to the respective output.

In an aspect, a, in particular each, resonant capacitor has a respective resonant input end, connected to the respective LF input and a respective resonant output end, connected to the respective output.

The input end of a, in particular each, resonant capacitor may be identical to the resonant input end of the corresponding resonant circuit, respectively.

The input end of a, in particular each, resonant inductor may be identical to the resonant input end of the corresponding resonant circuit, respectively.

The output end of a, in particular each, resonant capacitor may be identical to the resonant output end of the corresponding resonant circuit, respectively.

The output end of a, in particular each, resonant inductor may be identical to the resonant output end of the corresponding resonant circuit, respectively.

In an aspect, a, in particular each, resonant inductor is electrically connected between the second inductor and the output.

In such a way, the aforementioned object can be achieved even better.

In an aspect, a, in particular each, LF circuit comprises a LF grounding capacitor. The LF grounding capacitor comprises a grounding end and a signal end. The LF grounding capacitor is electrically connected with its signal end at the point between the LF input and the resonant input end of the resonant circuit. The LF grounding capacitor is electrically connected with its grounding end at ground.

In such a way, the aforementioned object can be achieved even better.

In an aspect, the housing is connected to ground.

In such a way, the aforementioned object can be achieved even better.

In an aspect, the housing is divided by a RF-partition-plate into two spaces, a RF space and a control space.

In such a way, the aforementioned object can be achieved even better.

In an aspect, the RF-partition-plate is set in a T-shape, the RF space is separated by a RF-partition-plate which separates two sets of matching circuits, respectively arranged in two RF spaces.

In such a way, the aforementioned object can be achieved even better.

In an aspect, the RF-partition-plate is connected to ground.

In such a way, the aforementioned object can be achieved even better.

In an aspect, a, in particular each, first variable capacitor comprises a respective first control mechanism.

In such a way, the aforementioned object can be achieved even better.

In an aspect, a, in particular each, second variable capacitor comprises a respective second control mechanism.

In such a way, the aforementioned object can be achieved even better.

In an aspect, the first and/or the second control mechanism extend into the respective control space.

In such a way, the aforementioned object can be achieved even better. In an aspect, an electrical cable, connection, or line from one space to the other may be connected to a filter component which is attached and connected to the RF-partition-plate, in particular to the grounded partition plate, where this is going through. Such a filter may comprise an inductive element and/or a capacitive element.

In such a way, the aforementioned object can be achieved even better.

In an aspect, a first motor is provided in the control space for driving the respective first variable capacitor. In such a way, the aforementioned object can be achieved even better.

In an aspect, a second motor is provided in the control space to drive the respective second variable capacitor.

In such a way, the aforementioned object can be achieved even better.

In an aspect, a fan or fan set for cooling the RF space is arranged at the position corresponding to each RF space, in particular attached to the housing, especially on the outside of the housing.

In such a way, the aforementioned object can be achieved even better.

In an aspect, the fan or fan set includes at least one fan corresponding to at least one or more of the first variable capacitors, second variable capacitors, first inductors, second inductors, or RF ground inductors.

In such a way, the aforementioned object can be achieved even better.

In an aspect, ventilation holes are provided in an array arrangement on the side walls of the housing opposite each fan.

In such a way, the aforementioned object can be achieved even better.

In an aspect, the position of the corresponding ventilation hole on the outer wall of the shell is fixedly connected with the dust baffle plate that has formed an auxiliary hole array, and the orthographic projection of the auxiliary hole and the ventilation hole does not coincide at least partially.

In such a way, the aforementioned object can be achieved even better.

Through the above-mentioned technical scheme, the application can achieve the following technical effects:
Through a set of circuits, the dual-frequency input can be used separately or together, and the impedance matching of different frequencies can be completed.

With a more compact layout of electronic components, the space requirements for matching circuits are further reduced.

The integration of two sets of matching circuits in one matching device is suitable for compact systems, improving space utilization and system integration.

A common ground for more than one matchbox, a common housing also connectable to the common ground and the possibility to connect all plugs for inputs and outputs to this common ground reduces the oscillations in designs with distributed matchboxes all around the plasma chamber.

### Description of the drawings:

Fig. 1 is a schematic diagram of the module of the matching equipment,
Fig. 2 is the diagram of matching circuit layout,
Fig. 3 is a schematic diagram of the matching circuit,
Fig. 4 is a schematic diagram of the matching equipment,
Fig. 5 is a schematic diagram of the fan set,
Fig. 6 is a schematic diagram of the internal layout of the matching equipment.

The specific embodiment:
In one embodiment of the present application, a matching device 2 is disclosed, comprising a housing 21, and two sets of matching circuits 1 are arranged in the housing for carrying out impedance matching operations of RF and LF.

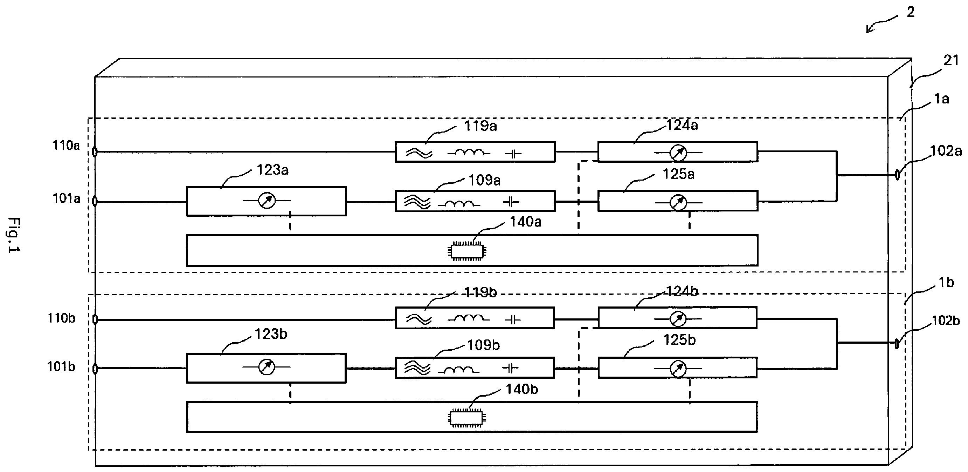

As shown in Fig. 1 two sets of matching circuits 1a, 1b comprise a LF input terminal 110a, 110b and a RF input terminal 101a, 101b.

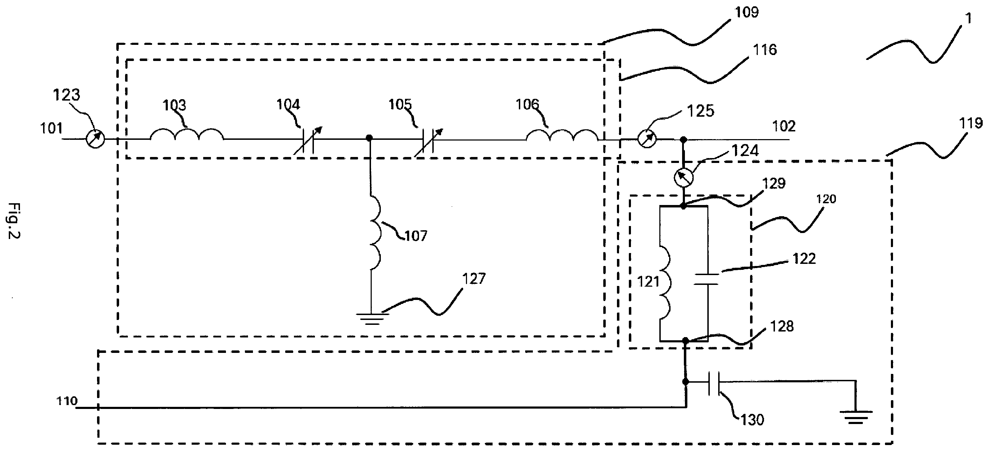

In Fig. 2 only one of those two sets of matching circuits 1 is shown. The references in Fig. 2 have the same numbers as in Fig. 1 but without the additional letter "a" and "b", as shown in Fig. 1. This was done to distinguish between the two sets of matching circuits 1a, 1b. The LF input terminal 110, 110a, 110b is connected to the output terminal 102, 102a, 102b through LF circuit 119, 119a, 119b. The RF input terminal 101, 101a, 101b is connected to the output terminal 102, 102a, 102b through RF circuit 109, 109a, 109b.

As shown in Fig 2, An output measurement module 124 is arranged between the output terminal 102 and the LF circuit 119. An output measurement module 125 is arranged between the output terminal 102 and the RF circuit 109. an input measurement module 123 is arranged between the RF input terminal 101 and the RF circuit 109.

As shown in Fig 1, An output measurement module 124a,124b, is arranged between the output terminal 102a, 102b and the LF circuit 119a, 119b. An output measurement module 125a, 125b is arranged between the output terminal 102a, 102b and the RF circuit 109a, 109b. An input measurement module 123a, 123b is arranged between the RF input terminal 101a, 101b and the RF circuit 109a, 109b. All input measurement modules 123a, 123b and all output measurement modules 124a,124b, 125a, 125b are connected to their respective control boards 140a, 140b.

Thus, the matching device can realize two sets of RF input terminals or LF input terminals and realize two outputs in parallel. Furthermore, the RF input terminal and LF input terminal can be used separately or together in each matching circuit, facilitating a wider range of applications.

Through the cooperation of the control board and the measurement module, it can be beneficial for the user to observe the parameters in real time, and control and adjust the operation of the entire matching circuit in time.

As shown in Fig. 2, the matching circuit 1 comprises a RF circuit 109. The RF input terminal 101 is electrical connected with the RF circuit 109. The first inductor 103, the first variable capacitor 104, the second variable capacitor 105, and the second inductor 106 are comprised by RF circuit 109 and sequentially connected between the RF input terminal 101 and the output terminal 102. The first inductor 103, the first variable capacitor 104, the second variable capacitor 105, and the second inductor 106 are connected in a series connection 116. At the position between the first variable capacitor 104 and the second variable capacitor 105, the electrical connection has a RF ground inductor 107. The RF ground inductor 107 is connected to ground 127 at the other end. Through the above-mentioned circuit, the RF circuit with T-shaped layout is realized. It may be that the input frequency of the RF input terminal 101 is 13.56 MHz.

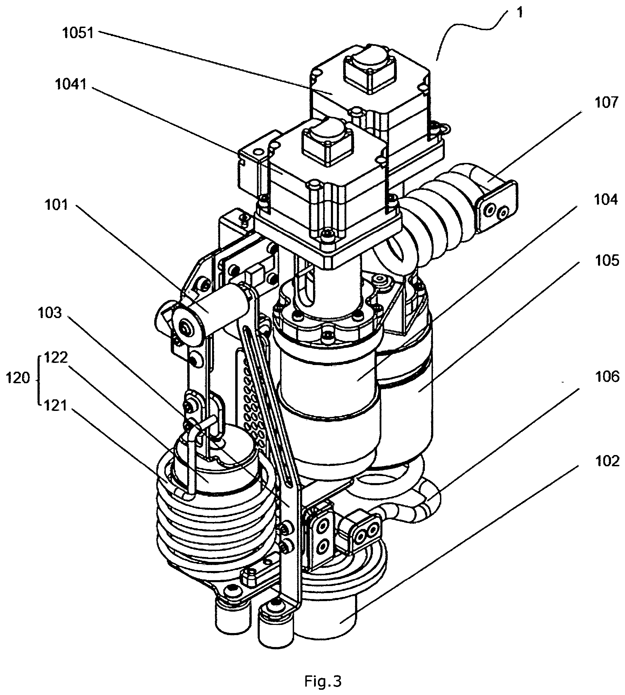

In Fig. 3 is shown a schematic diagram of the matching circuit, with the same parts as in Fig. 2.

The first variable capacitor 104 and the second variable capacitor 105 are controlled by the first motor 1041 and the second motor 1051 respectively.

The first motor 1041 and the second motor 1051 are used to adjust the capacitor value of the capacitors 104, 105, so as to achieve a wider matching range and improve the matching ability.

As shown in Fig. 2, the matching circuit 1 further comprises a LF circuit 119, the LF input terminal 110 is electrical connected with the LF circuit 119, the LF circuit 119 further comprises a resonant circuit 120 and is electrically connected to the output terminal 102 through the respective resonant circuit 120, wherein the resonant circuit 120 have an resonant input end 128 and an resonant output end 129, between the resonant input end 128 and the resonant output end 129, the resonant circuit 120 comprises a resonant inductor 121 and a resonant capacitor 122 connected in parallel. The position between the LF input terminal 110 and the resonant circuit 120 is electrically connected with a LF grounding capacitor 130, and the other end of the LF grounding capacitor 130 is grounded. Thus, the LF input terminal 110 and impedance matching functions can be realized through the LF input terminal, and the switching between different input sources can be realized through the resonant circuit 120. Cooperate with the RF input terminal to realize the function of use LF input or RF input in separately or together.

Setting a resonant circuit 120 in the matching circuit of dual frequency input can realize the following functions:
1. Frequency selection and filter frequency selection: The resonant circuit presents the maximum impedance at the resonant frequency, e.g. at 380 kHz, which has high selectivity for the target LF signal, allowing the frequency signal to pass through efficiently, and at the same time suppressing the interference of other frequencies, such as e.g., high-frequency 13.56 MHz crosstalk. Out-of-band rejection: By adjusting the figure of merit, e.g. the Q value, of the resonant circuit, the bandwidth can be controlled to further filter out noise or spurious signals in the non-target frequency band, ensuring the purity of LF signals.
2. Impedance matching optimizes power transmission: In the resonant state, the resonant circuit can be equivalent to pure resistive impedance, and through reasonable design parameters, such as inductor and capacitor value, the impedance matching between the LF input port and the load can be realized, reducing signal reflection and improving energy transmission efficiency. Isolation of high-frequency influence: Due to the high impedance characteristics of parallel resonance, e.g. at 380 kHz, the interference of high-frequency, e.g. at 13.56 MHz, circuits to LF parts can be effectively isolated, and mutual crosstalk between dual-frequency signals can be avoided.
3. Signal enhancement and stability voltage amplification: When resonating in parallel, the energy storage characteristics of the inductor and capacitor will cause the voltage to increase significantly near the resonance point, thereby enhancing the amplitude of the LF signal. Anti-interference: The high impedance characteristics of the resonant circuit can suppress the current passage of non-resonant frequencies, reduce the influence of external electromagnetic interference on LF signals, and improve system stability.
4. Independent tuning of dual-frequency co-design: The resonant circuit only acts on the LF input, allowing the high-frequency, e.g. 13.56 MHz, channel to be independently designed through other matching structures, such as series resonance or band-pass filter, to achieve parallel processing of dual-frequency signals. Frequency isolation: Through the impedance characteristics of parallel resonance, LF and high-frequency signals can be transmitted in the same system without interfering with each other, meeting the requirements of dual-frequency application scenarios, such as supporting RFID and LF communication at the same time.

As shown in Fig. 3, in any embodiment, the resonant inductor 121 is arranged in a coil and around the resonant capacitor 122, so that the required space can be reduced while maintaining function, and the integration of the physical device can be improved.

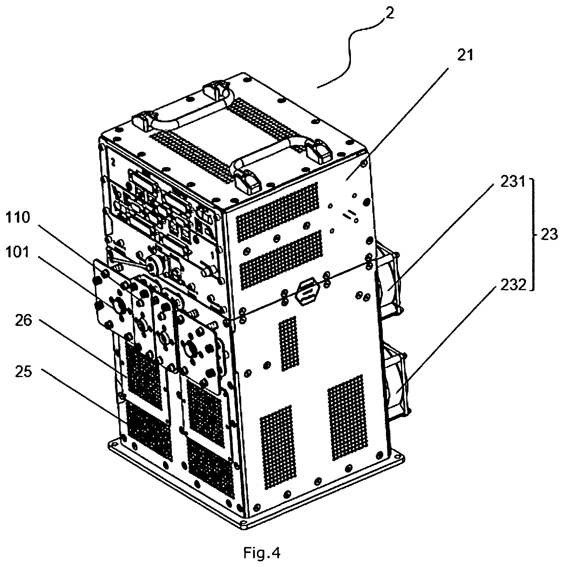

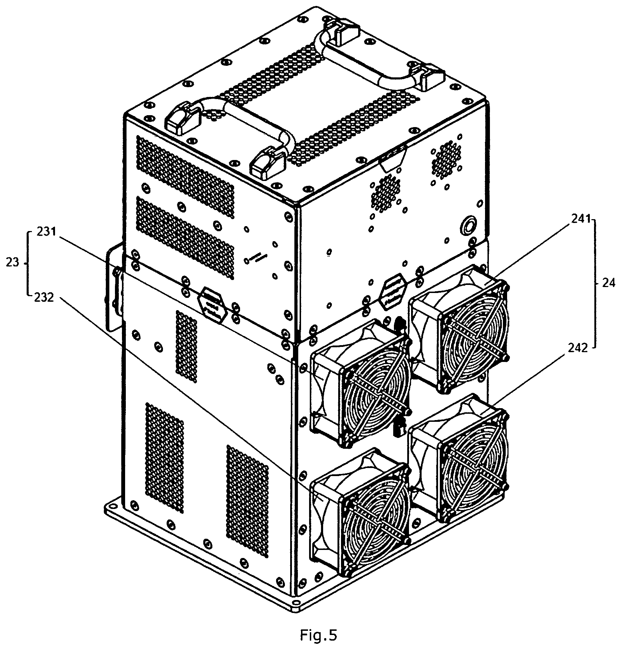

As shown in Fig. 4 to Fig. 6, the housing 21 disclosed in any embodiment of the present application is used for wrapping all components.

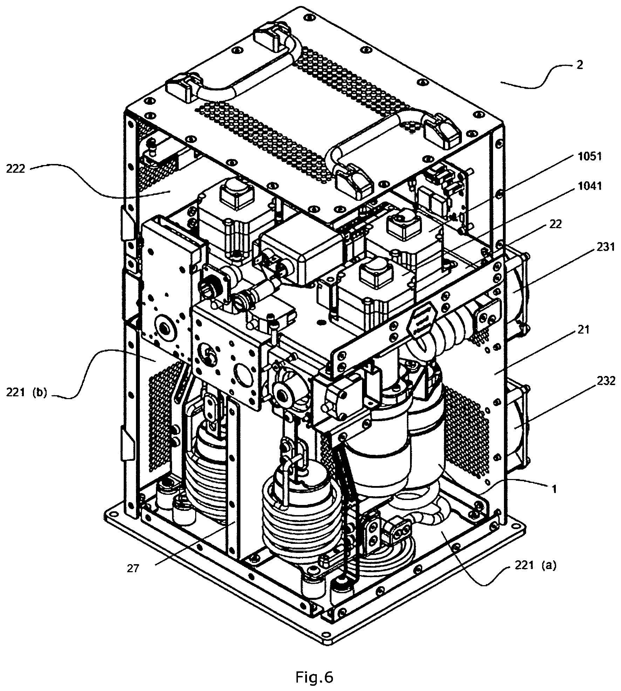

As shown in Fig. 6, a T-shape RF-partition-plate 27 is arranged in the housing 21, the internal space can be divided into two RF spaces 221 and a control space 222, the RF space is divided into a first RF space 221 (a) and a second RF space 221 (b) through the partition RF-partition-plate 27, so that two sets of the matching circuits 1 can be accommodated simultaneously in the housing 21. The control of two sets of matching circuits may be carried out centrally through the circuit boards and the like in the control space 222. Further improve space utilization and equipment integration.

As shown in Fig. 4 in combination with Fig. 6, the control terminals of all the first variable capacitors 104 and the second variable capacitors 105 extend into the control space 222, and the first motor 1041 for controlling the first variable capacitor 104 and the second motor 1051 for controlling the second variable capacitor 105 are arranged in the control space 222, and the capacitor values of the first variable capacitor 104 and the second variable capacitor 1055 are adjusted through the first motor 1041 and the second motor 1051, so that the matching circuit 1 realizes a wider matching range.

As shown in Fig. 4 to Fig. 6, the first fan set 23 and the second fan set 24 are respectively arranged at the positions corresponding to the first RF space 221 (a) and the second RF space 221 (b) on the outer side of the housing 21, and the air flow is introduced or drawn out to the first RF space 221 (a) and the second RF space 221 (b) respectively through the two fan sets, so that the cooling effect of electronic components is realized.

As shown in Fig. 4 to Fig. 6, the first fan set 23 comprise two fans 231, 232. The second fan set 24 comprise two fans 241, 242. One of those fan sets 231 and 241 are respectively oriented towards the RF grounding inductors 107 of two sets of matching circuits 1. The other of those fan sets 232 and 242 are respectively oriented towards the second variable capacitors 105 of two sets of matching circuits 1. During the operation of the matching equipment, the capacitors and inductors may be the places where the most heat is generated, so a targeted air-cooled layout enables higher cooling efficiency.

As shown in Figure 4 to Figure 6, vent holes 25 are formed in the side walls of the opposite sides of the first fan set 23 and the second fan set 24 corresponding to the housing 21, which are used for cooperating with the first fan set 23 and the second fan set 24 to achieve better ventilation and heat dissipation effect. Further, dust baffles 26 are fixedly connected to the outer side walls of the corresponding vent holes 25 positions of the shell 21, auxiliary vents 261 are formed in the dust baffles 26, and the orthographic projection of the auxiliary vents 261 and the vents 25 does not coincide completely. Thus, in the dusty use scenario, it is possible to avoid dust entering the inside of the housing 21 while maintaining the ventilation effect.

In summary, the matching device 2 disclosed in any embodiment of the present application can carry out two independent impedance matching operations from the input terminal to the output terminal through the application of two sets of matching circuits 1, and each set of matching circuits can realize the input of multiple frequencies, e.g. RF and LF, and realize use multiple inputs separately or together , so that the matching device 2 can simultaneously complete the impedance matching between the two inputs and the inputs, and each set of outputs can correspond to two sets of inputs of different frequencies. The integration and adaptability of matching devices are further expanded.

It has been found out that a RF-system, e.g. a RF plasma processing system, with a multi-output matching device 2 which comprises one housing 21; several sets of matching circuits 1 which are arranged in the housing 21, wherein each set of matching circuits 1 comprises: an output 102, an RF input 101, an LF input 110, an RF circuit 109, electrically connected between the respective RF input 101 and the respective output 102, for realizing the impedance matching from the respective RF input 101 to the respective output 102; and an LF circuit 119, electrically connected between the respective LF input 110 and the respective output 102, behaves much more stable and the tendency to unwanted oscillations is considerable low.

This positive effect might be a result to the fact, that all parts are connectable to the same reference potential ground 127, to which also the common housing 21 may be connected. Additionally, a control 140 which might be also a common control may have this common reference potential.

So, the disadvantages related to ground loops, caused by several ground cables between several controls, several matching devices in several housings, as known from the past and prone to malfunctions may be reduced. As described in the following, those positive effects could even be enhanced by one or a combination of the following features:
It has been found out that a circuit arrangement, wherein if the matching device 2 comprises a resonant circuit 120 comprising a resonant inductor 121 and a resonant capacitor 122 connected electrically in parallel, is much more stabile against unwanted interference and oscillations.

It has been found out that a circuit arrangement, wherein a, in particular each, resonant inductor 121 is spatially arranged around the respective resonant capacitor 122 connection lines may be reduced. This might also lead to less oscillations.

It has been found out that a circuit arrangement, wherein a, in particular each, RF circuit 109 comprises a first inductor 103, a first variable capacitor 104, a second variable capacitor 105, and a second inductor 106, several of, in particular all, those components connected in a series connection 116) wherein an input end of the first inductor 103 is connected to the RF input 101, and an output end of the second inductor 106 is connected to the output 102, is much more stabile against unwanted interference and oscillations.

It has been found out that a circuit arrangement wherein a, in particular each, RF circuit 109 comprises an RF grounding inductor 107, with a grounding end and a signal end, the grounding end of the RF grounding inductor 107 is connected with ground 127, in particular with the housing 21, and the signal end of the RF grounding inductor 107 is electrically connected between the RF input 101 and the output 102, is much more stabile against unwanted interference and oscillations.

It has been found out that a circuit arrangement wherein a, in particular each, RF grounding inductor 107 is electrically connected between the respective first variable capacitor 104 and the respective second variable capacitor 105, is much more stabile against unwanted interference and oscillations.

It has been found out that a circuit arrangement wherein a, in particular each, resonant circuit 120 comprises a respective resonant input end 128, connected to the respective LF input 110 and a respective resonant output end 129, connected to the respective output 102, is much more stabile against unwanted interference and oscillations.

It has been found out that a circuit arrangement wherein a, in particular each, resonant inductor 121 comprises a respective resonant input end 128, connected to the respective LF input 110 and a respective resonant output end 129, connected to the respective output 102, is much more stabile against unwanted interference and oscillations.

It has been found out that a circuit arrangement wherein a, in particular each, resonant capacitor 1221 comprises a respective resonant input end 128, connected to the respective LF input 110 and a respective resonant output end 129, connected to the respective output 102, is much more stabile against unwanted interference and oscillations.

It has been found out that a circuit arrangement wherein an, in particular each, output end 129 of the respective resonant inductor 121 is electrically connected between the second inductor 106 and the output 102, is much more stabile against unwanted interference and oscillations.

It has been found out that a circuit arrangement wherein the LF circuit 119 comprises a LF grounding capacitor 130 with a grounding end and a signal end, and the signal end of the LF grounding capacitor 130 is electrically connected between the LF input 110 and the resonant input end 128 of the resonant circuit 120, is much more stabile against unwanted interference and oscillations.

It has been found out that an arrangement wherein the housing 21 is separated by a RF-partition-plate 27 into two spaces, a RF space 221 and a control space 222, is much more stabile against unwanted interference and oscillations.

It has been found out that an arrangement wherein the housing 21 is separated by a RF-partition-plate 27 which separates two sets of matching circuits 1, respectively arranged in two RF spaces 221a, 221b.

It has been found out that a circuit arrangement wherein a, in particular each, first variable capacitor 104 comprises a respective first control mechanism, is much more stabile against unwanted interference and oscillations.

It has been found out that a circuit arrangement wherein a, in particular each, second variable capacitor 105 comprises a respective second control mechanism, is much more stabile against unwanted interference and oscillations.

It has been found out that a circuit arrangement wherein the first and/or the second control mechanism extend into the respective control space 27, is much more stabile against unwanted interference and oscillations.

It has been found out that an arrangement wherein in the control space 222, a first motor 1041 is provided for driving the respective first variable capacitor 104, is much more stabile against unwanted interference and oscillations.

It has been found out that an arrangement wherein a second motor 1051 is provided for driving the respective second variable capacitor 105, is much more stabile against unwanted interference and oscillations.

It has been found out that an arrangement with a fan or a fan set for cooling the RF space 221 is arranged at the position of each RF space 221, in particular attached to the housing, especially on the outside of the housing 21, is much more stabile against unwanted interference and oscillations.

It has been found out that an arrangement wherein the fan or fan set comprises at least one or more fans corresponding to at least one or more of the first variable capacitors 104, the second variable capacitors 105, the first inductors 103, the second inductors 106, or RF grounding inductors 107, is much more stabile against unwanted interference and oscillations.

It has been found out that an arrangement wherein an array of ventilation holes 25 is arranged in a side wall which is different from the walls where the fans are arranged, in particular opposite each fan of the housing 21, is much more stabile against unwanted interference and oscillations.

It has been found out that an arrangement wherein the outer wall of the housing 21 is fixedly connected with a dust baffle 26 with an array of auxiliary holes at the positions corresponding to the ventilation holes 25, and the auxiliary holes do not coincide with at least part of the orthographic projection of the ventilation holes, is much more stabile against unwanted interference and oscillations.

## Claims

1. A multi-output matching device (2) comprises
- a housing (21);
- several sets of matching circuits (1) which are arranged in the housing (21), each set of matching circuits (1) comprises:
- an output (102);
- an RF input (101);
- an LF input (110);
- an RF circuit (109), electrically connected between the respective RF input (101) and the respective output (102), for realizing the impedance matching from the respective RF input (101) to the respective output (102); and
- an LF circuit (119), electrically connected between the respective LF input (110) and the respective output (102).

2. The matching device of claim 1, wherein a, in particular each, LF circuit (119) comprises a resonant circuit (120) which comprises a resonant inductor (121) and a resonant capacitor (122) connected electrically in parallel, respectively.

3. The matching device of claim 2, wherein a, in particular each, resonant inductor (121) is spatially arranged around the respective resonant capacitor (122).

4. The matching circuit of claim 1, wherein: a, in particular each, RF circuit (109) comprises a first inductor (103), a first variable capacitor (104), a second variable capacitor (105), and a second inductor (106), several of, in particular all, those components connected in a series connection (116), wherein an input end of the first inductor (103) is connected to the RF input (101), and an output end of the second inductor (106) is connected to the output (102).

5. The matching device of claim 4, wherein a, in particular each, RF circuit (109) comprises an RF grounding inductor (107), with a grounding end and a signal end, the grounding end of the RF grounding inductor (107) is connected with ground (127), in particular with the housing (21), and the signal end of the RF grounding inductor (107) is electrically connected between the RF input (101) and the output (102).

6. The matching device of claim 5, wherein a, in particular each, RF grounding inductor (107) is electrically connected between the respective first variable capacitor (104) and the respective second variable capacitor (105).

7. The matching device of any one of claims 4-6, wherein a, in particular each, resonant circuit (120) has a respective resonant input end (128), connected to the respective LF input (110) and a respective resonant output end (129), connected to the respective output (102),
wherein a, in particular each, resonant inductor (121) has a respective resonant input end (128), connected to the respective LF input (110) and a respective resonant output end (129), connected to the respective output (102)
wherein a, in particular each, resonant capacitor (1221) has a respective resonant input end (128), connected to the respective LF input (110) and a respective resonant output end (129), connected to the respective output (102)

8. The matching device of any one of claims 4-6, wherein an, in particular each, output end (129) of the respective resonant inductor (121) is electrically connected between the second inductor (106) and the output (102).

9. The matching device of claims 1-6, wherein the LF circuit (119) comprises a LF grounding capacitor (130) with a grounding end and a signal end, and the signal end of the LF grounding capacitor (130) is electrically connected between the LF input (110) and the resonant input end (128) of the resonant circuit (120).

10. The matching device of any one of claims 1-6, wherein the housing (21) is separated by a RF-partition-plate (27) into two spaces, a RF space (221) and a control space (222);

11. The matching device of any one of claims 1-6, wherein the housing (21) is separated by a RF-partition-plate (27) which separates two sets of matching circuits (1), respectively arranged in two RF spaces (221a, 221b).

12. The matching device of claim 9, wherein
- a, in particular each, first variable capacitor (104) comprises a respective first control mechanism and
- a, in particular each, second variable capacitor (105) comprises a respective second control mechanism, wherein
- the first and/or the second control mechanism extend into the respective control space (27).

13. The matching device of claim 10, wherein:
in the control space (222), a first motor (1041) is provided for driving the respective first variable capacitor (104);
a second motor (1051) is provided for driving the respective second variable capacitor (105).

14. The matching device of claim 9, wherein: a fan or a fan set for cooling the RF space (221) is arranged at the position of each RF space (221), in particular attached to the housing, especially on the outside of the housing (21).

15. The matching device of claim 14, wherein the fan or fan set comprises at least one or more fans corresponding to at least one or more of the first variable capacitors (104), the second variable capacitors (105), the first inductors (103), the second inductors (106), or RF grounding inductors (107).

16. The matching device of claim 12, wherein an array of ventilation holes (25) is arranged in a side wall which is different from the walls where the fans are arranged, in particular opposite each fan of the housing (21).

17. The matching device of claim 10, wherein the outer wall of the housing (21) is fixedly connected with a dust baffle (26) with an array of auxiliary holes at the positions corresponding to the ventilation holes (25), and the auxiliary holes do not coincide with at least part of the orthographic projection of the ventilation holes.
